# EUROPEAN PATENT SPECIFICATION

(11) **EP 2 818 856 B1**
(45) Date of publication and mention of the grant of the patent: **25.04.2018**
(21) Application number: 13752073.0
(22) Date of filing: 15.02.2013
(51) Int. Cl.: G01N 27/90, G01R 33/06

(54) **EDDY-CURRENT INSPECTION METHOD AND DEVICE**
WIRBELSTROMPRÜFVERFAHREN UND VORRICHTUNG
PROCÉDÉ ET DISPOSITIF D'INSPECTION PAR COURANT DE FOUCAULT

(30) Priority: 20.02.2012 JP 2012033827
(43) Date of publication of application: 31.12.2014
(73) Proprietor: IHI Corporation, Tokyo 135-8710 (JP)
(72) Inventor: TSUDA, Akinori, Tokyo 135-8710 (JP); HATANAKA, Hiroaki, Tokyo 135-8710 (JP); KAWAI, Hiroki, Tokyo 135-8710 (JP)
(74) Representative: Epping - Hermann - Fischer
(86) International application number: PCT/JP2013/053676
(87) International publication number: WO 2013/125462

(56) References cited:
- EP-A2- 0 990 919
- WO-A1-2007/095971
- JP-A- S6 227 675
- JP-A- 2001 183 347
- JP-A- 2001 183 347
- JP-A- 2006 343 300
- JP-A- 2006 343 300
- JP-A- 2011 013 087
- VACHER ET AL: "Eddy current nondestructive testing with giant magneto-impedance sensor", NDT & E INTERNATIONAL, BUTTERWORTH-HEINEMANN, OXFORD, GB, vol. 40, no. 6, 13 June 2007 (2007-06-13), pages 439-442, XP022114599, ISSN: 0963-8695
- F.VACHER ET AL.: 'Eddy current nondestructive testing with giant magnet-impedance sensor' NDT&E INTERNATIONAL vol. 40, no. 6, 13 June 2007, pages 439 - 442, XP022114599

## Description

### Technical Field

The present invention relates to a method and apparatus for eddy-current flaw detection, and particularly to a method and apparatus for eddy-current flaw detection using a magnetoimpedance effect device.

### Background Art

Conventionally, eddy-current flaw detection using a magnetic sensor has been practiced in order to detect flaws present in the interiors and on the surfaces of a test object, for example, an electrical conductor such as a metallic material. Examples of such a magnetic sensor used in eddy-current flaw detection include a flux-gate sensor, a giant magnetoresistive sensor (GMR sensor), and a magnetic impedance sensor (hereinafter referred to as the MI sensor). Among these examples, the MI sensor is particularly high in sensitivity. It is therefore possible to detect minor flaws present on the surfaces of the test object by performing eddy-current flaw detection using the MI sensor.

A magnetoimpedance effect device is used as the MI sensor. Examples of this magnetoimpedance effect device include an amorphous magnetic wire. When a high-frequency electric current is turned on through the amorphous magnetic wire, an external magnetic field causes the impedance of this wire to vary due to a skin effect. Such a phenomenon is referred to as a magnetoimpedance effect, and the amorphous magnetic wire which has this effect is called a magnetoimpedance effect device.

A method of inspecting a test object for flaws on the surfaces thereof has been practiced using the amorphous magnetic wire having such a magnetoimpedance effect (see Patent Document 1). In the European Patent Application EP0990919A2, a magnetoimpedance effect element driving circuit comprises: a magnetoimpedance element (MI element); an exciting coil for applying a biased magnetic field to the MI element; a coil driving circuit for alternating the direction of a current flowing through the exciting coil; and an element driving circuit for driving the MI element in synchronism with the coil driving circuit.

### Prior Art Document

### Patent Documents

Patent Document 1: Japanese Patent Laid-Open No. 2001-183347 and European Patent Application EP0990919A2

### Summary of the Invention

### Problems to be solved by the Invention

Incidentally, voltages having predetermined frequencies are applied to an exciting coil and an amorphous magnetic wire, respectively, when eddy-current flaw detection is performed using the amorphous magnetic wire. In this case, the phase of the voltage applied to the amorphous magnetic wire may deviate in some cases from the phase of the voltage applied to the exciting coil. This is because a minor mismatch may arise between the frequency of the voltage applied to the exciting coil and the frequency of the voltage applied to the amorphous magnetic wire. Such a phase deviation remains as noise when the variation of a magnetic field is measured and is, therefore, unfavorable since the phase deviation can be a cause for a degradation in the accuracy of detecting flaws in a test object.

In this regard, the technique disclosed in Patent Document 1 mentioned above remains to be problematic since the technique is designed to detect flaws on the surfaces of the test object, with no intention to reduce the noise, by disposing the amorphous magnetic wire in a direction parallel to the winding direction of the exciting coil.

An object of the present invention, which has been accomplished in order to solve the above-described problem, is to provide a method and apparatus for eddy-current flaw detection capable of precisely measuring flaws present in a test object by means of eddy-current flaw detection.

### Means for Solving the Problems

In order to achieve the above-described object, an eddy-current flaw detection method as defined in claim 1 includes a synchronization step of synchronizing the phase of an exciting voltage applied by coil driving means to an exciting coil for generating an eddy current in a test object with the phase of a driving voltage, higher in frequency than the exciting voltage, applied by device driving means to a magnetoimpedance effect device for detecting variation of a magnetic field arising in the exciting coil; and a magnetic field detection step of detecting the variation of the magnetic field arising in the exciting coil due to the eddy current generated in the test object using the magnetoimpedance effect device.

In an eddy-current flaw detection method as defined in claim 2, the synchronization step in the eddy-current flaw detection method of claim 1 is carried out as the result of a trigger signal being input from the coil driving means to the device driving means, wherein upon input of the trigger signal, the driving voltage is output from the device driving means in the form of a burst wave.

An eddy-current flaw detection apparatus as defined in claim 4 includes an exciting coil for generating an eddy current in a test object; a magnetoimpedance effect device for detecting a variation in the magnetic field of the exciting coil; coil driving means for exciting the exciting coil by applying an exciting voltage having a predetermined frequency to the exciting coil; device driving means for applying a driving voltage, higher in frequency than the voltage of the exciting coil, to the magnetoimpedance effect device; and synchronization means for synchronizing the phase of the exciting voltage applied by the coil driving means with the phase of the driving voltage applied by the device driving means.

In an eddy-current flaw detection apparatus as defined in claim 5, the synchronization means in the eddy-current flaw detection apparatus of claim 4 outputs a driving voltage from the device driving means in the form of a burst wave when a trigger signal is input from the coil driving means to the device driving means.

### Advantageous Effects of the Invention

According to the eddy-current flaw detection method as defined in claim 1, a time point when the exciting voltage is applied to the exciting coil and a time point when the driving voltage is applied to the magnetoimpedance effect device are synchronized, and therefore, a deviation of the phase of the driving voltage from the phase of the exciting voltage at any time points therein does not occur.

Consequently, noise arising from a phase deviation is reduced, and therefore, it is possible to more precisely detect flaws present on the surfaces of the test object.

According to the eddy-current flaw detection apparatus as defined in claim 4, a time point at which the exciting voltage is applied to the exciting coil and a time point at which the driving voltage is applied to the magnetoimpedance effect device are synchronized at predetermined time intervals. Consequently, there is obtained the same advantageous effect as discussed in claim 1.

### Brief Description of the Drawings

FIG. 1 is a schematic configuration diagram of an eddy-current flaw detection apparatus according to the present invention.
FIG. 2 is a flowchart illustrating an eddy-current flaw detection method according to the present invention.
FIG. 3 is a signal waveform illustrating a synchronized exciting coil driving signal and wire driving signal.
FIG. 4A is a top view of a test object in which an artificial flaw is formed.
FIG. 4B is a cross-sectional view taken along the IV-IV line of FIG. 4A.
FIG. 5A is a drawing illustrating one example of flaw detection results obtained by performing a flaw detection method according to the present invention.
FIG. 5B is a drawing illustrating one example of flaw detection results obtained by performing a conventional flaw detection method.
FIG. 6A is a drawing illustrating another example of flaw detection results obtained by performing the flaw detection method according to the present invention.
FIG. 6B is a drawing illustrating another example of flaw detection results obtained by performing the conventional flaw detection method.
FIG. 7A is a drawing illustrating yet another example of flaw detection results obtained by performing the flaw detection method according to the present invention.
FIG. 7B is a drawing illustrating yet another example of flaw detection results obtained by performing the conventional flaw detection method.

### Mode for Carrying out the Invention

Hereinafter, embodiments of the present invention will be described while referring to the accompanying drawings.

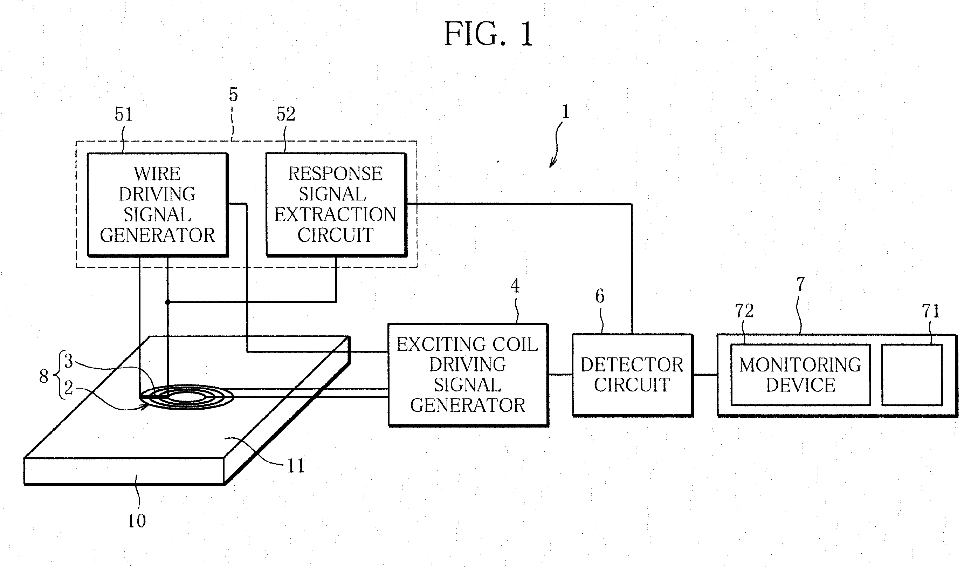

FIG. 1 is a schematic configuration diagram of an eddy-current flaw detection apparatus according to the present invention. An eddy-current flaw detection apparatus 1 is provided with an exciting coil 2, an amorphous magnetic wire (magnetoimpedance effect device) 3, an exciting coil driving signal generator (coil driving means) 4, a sensor circuit 5, a detector circuit 6, and a personal computer (hereinafter referred to as the PC) 7.

The exciting coil 2 is a whorl-like coil, and the amorphous magnetic wire 3 is disposed so as to extend from the center side of the exciting coil 2 toward the outer edge of the exciting coil in the radial direction thereof. The exciting coil 2 and the amorphous magnetic wire 3 configured as described above function as a probe 8. The probe 8 is disposed on an inspection surface 11 of a test object 10 to inspect the inspection surface 11 with the probe 8. Note that the exciting coil 2 may be an air-cored coil or the like. The test object 10 is made of an electrically conductive material, and examples of the material include metallic bodies, such as iron, aluminum, titanium, and stainless steel, an electrically conductive carbon-based material, and a metallic structure.

The exciting coil driving signal generator 4 is used to apply a predetermined signal frequency, i.e., a voltage having a predetermined frequency, to the exciting coil 2. By bringing the exciting coil 2 excited by the exciting coil driving signal generator 4 close to the inspection surface 11 of the test object 10, an eddy current is generated on the inspection surface 11.

The sensor circuit 5 includes a wire driving signal generator (device driving means) 51, and a response signal extraction circuit 52. The wire driving signal generator 51 is used to apply a predetermined signal frequency, i.e., a voltage having a predetermined frequency, to the amorphous magnetic wire 3. The response signal extraction circuit 52 outputs a voltage according to an impedance change in the amorphous magnetic wire 3.

The detector circuit 6 synchronously detects the voltage extracted by the response signal extraction circuit 52, i.e., the response signal of the amorphous magnetic wire 3, using the voltage of the exciting coil driving signal generator 4 as a reference signal, and outputs amplitude and phase information.

The PC 7 is provided with an arithmetic device 71 and a monitoring device 72. The arithmetic device 71 processes a signal input from the detector circuit 6, so that a signal based on a surface flaw can be easily discriminated from a noise signal, and displays the signal on the monitoring device 72.

The frequency of the voltage applied to the amorphous magnetic wire 3 is higher than the frequency of the voltage applied to the exciting coil 2. In order to detect defects, such as flaws, present on the inspection surface 11 of the test object 10, it is preferable to heighten the frequency of the voltage to be applied to the amorphous magnetic wire 3. Specifically, the frequency range of a voltage to be applied to the exciting coil 2 by the exciting coil driving signal generator 4 is preferably 100 kHz to 10 MHz, whereas the frequency range of a voltage to be applied to the amorphous magnetic wire 3 by the wire driving signal generator 51 is preferably 10 MHz or higher. The frequency of a voltage to be applied to the exciting coil 2 and the frequency of a voltage to be applied to the amorphous magnetic wire 3 are respectively selected according to the size of a flaw to be detected.

The exciting coil driving signal generator 4 is connected to the wire driving signal generator 51. This connection makes it possible to input a trigger signal from the exciting coil driving signal generator 4 to the wire driving signal generator 51, as will be described later.

An inspection of the test object 10 in the eddy-current flaw detection apparatus 1 of the present invention is performed by applying voltages having predetermined frequencies to the exciting coil 2 and the amorphous magnetic wire 3, respectively, bringing the probe 8 close to the test object 10, and moving the probe 8 along the test object 10 while exciting the exciting coil 2.

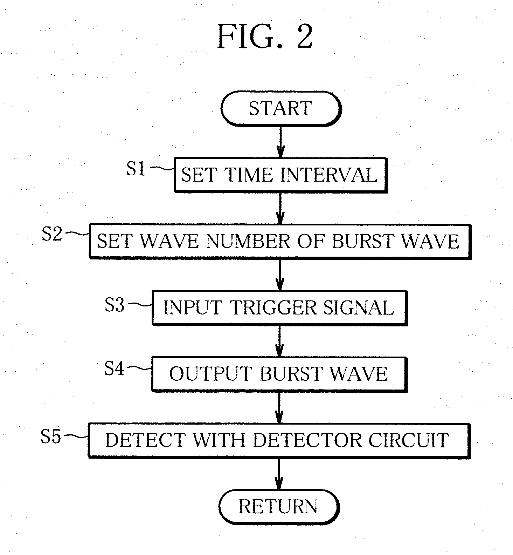

A description will be made of an eddy-current flaw detection method for inspecting the inspection surface 11 of the test object 10 using the eddy-current flaw detection apparatus 1 configured as described above. FIG. 2 illustrates a flowchart of the method for eddy-current detection of flaws on the inspection surface 11. Hereafter, the method will be described according to the flowchart. It is assumed that the frequency of a voltage to be applied by the exciting coil driving signal generator 4 and the frequency of a voltage to be applied by the wire driving signal generator 51 have been set preliminarily, respectively.

In step S1, a point of time to generate a trigger signal to be input to the wire driving signal generator 51 is set in the exciting coil driving signal generator 4. The point of time to generate the trigger signal is set so as to occur in synchronization with the frequency of the exciting coil driving signal generator 4. In the present embodiment, the exciting coil driving signal generator 4 is set so as to generate a trigger signal for each period of the frequency set therein.

In step S2, the wave number of a burst wave is set in the wire driving signal generator 51. The burst wave refers to a waveform signal that sustains a sine wave, a rectangular wave, a ramp wave, a pulse wave or the like for a specified period of time (i.e., the wave number) at predetermined time intervals. The wave number of a burst wave set in the above-mentioned step is preferably set so as to be as large as possible but no greater than the ratio of the frequency of the voltage applied to the exciting coil 2 to the frequency of the voltage applied to the amorphous magnetic wire 3 in one period of the frequency of the voltage applied to the exciting coil 2. For example, if the frequency of the voltage applied to the amorphous magnetic wire 3 is 15 MHz and the frequency of the voltage applied to the exciting coil 2 is 1 MHz, then the wave number of the burst wave is preferably 10 or larger. By increasing the wave number of the burst wave, it is possible to process a response signal from the amorphous magnetic wire 3 in the detector circuit 6. On the other hand, a small wave number of the burst wave in one period of the frequency of the voltage is not preferable since it may be difficult to process the response signal from the amorphous magnetic wire 3 in the detector circuit 6.

In step S3, the exciting coil 2 and the amorphous magnetic wire 3 are driven respectively and, when the phase of the voltage applied from the exciting coil driving signal generator 4 to the exciting coil 2 agrees with a generation point of time set in step S1 described above, a trigger signal is input from the exciting coil driving signal generator 4 to the wire driving signal generator 51 (synchronization step).

In step S4, a burst wave is applied from the wire driving signal generator 51 to the amorphous magnetic wire 3 at a frequency set preliminarily when the trigger signal is input to the wire driving signal generator 51 (synchronization step).

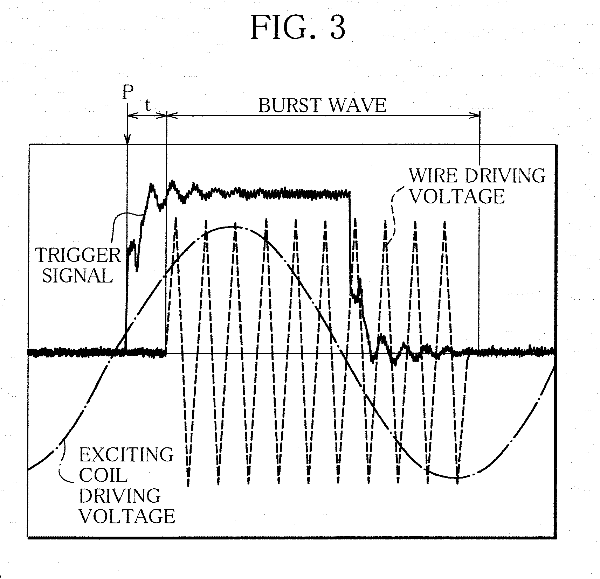

For details, FIG. 3 illustrates the waveforms of voltages applied respectively to the exciting coil 2 and the amorphous magnetic wire 3. As illustrated in FIG. 3, a trigger signal is generated at a point of time when the exciting coil driving voltage passes through a position P, and a burst wave of a wire driving voltage is output after a time t from the time point of the position P. Note that the time t is a predetermined block of time. The time t may not be present, however. Alternatively, the burst wave of the wire driving voltage may be output when a trigger signal is input to the wire driving signal generator 51.

In step S5, an impedance change in the amorphous magnetic wire 3 is detected by the detector circuit through the response signal extraction circuit 52 (magnetic field detection step).

As described above, in the present embodiment, a trigger signal is input from the exciting coil driving signal generator 4 to the wire driving signal generator 51 at a predetermined point of time. Upon input of the trigger signal, the wire driving signal generator 51 applies a voltage of a predetermined frequency to the amorphous magnetic wire 3.

Consequently, the phase of the frequency of the voltage applied to the exciting coil 2 and the phase of the frequency of the voltage applied to the amorphous magnetic wire 3 go into a synchronized state. This state makes it possible to reduce noise due to a phase deviation, and thereby, further improve the accuracy of flaw detection. Accordingly, it is possible to more precisely detect even minor flaws, 1 mm or smaller in size, present on the inspection surface 11 of the test object 10.

When the trigger signal is input from the exciting coil driving signal generator 4 to the wire driving signal generator 51, a voltage is applied from the wire driving signal generator 51 to the amorphous magnetic wire 3 in the form of a burst wave. Consequently, the phase of the frequency of the voltage applied to the exciting coil 2 and the phase of the voltage applied in the form of the burst wave to the amorphous magnetic wire 3 are always in a synchronized state. Accordingly, it is possible to reduce noise due to the phase deviation of these frequencies, and therefore, more precisely detect flaws present on the inspection surface 11.

Note that although an amorphous magnetic wire is used as the magnetoimpedance effect device in the above-described present embodiment, an amorphous magnetic ribbon or the like may be used instead.

### Examples

Hereinafter, the present invention will be described by citing examples. It should be noted however that the present invention is not limited to the examples described below.

Surface flaws were detected using the eddy-current flaw detection apparatus 1 and the above-described eddy-current flaw detection method according to the present invention, and using a titanium material as the test object 10.

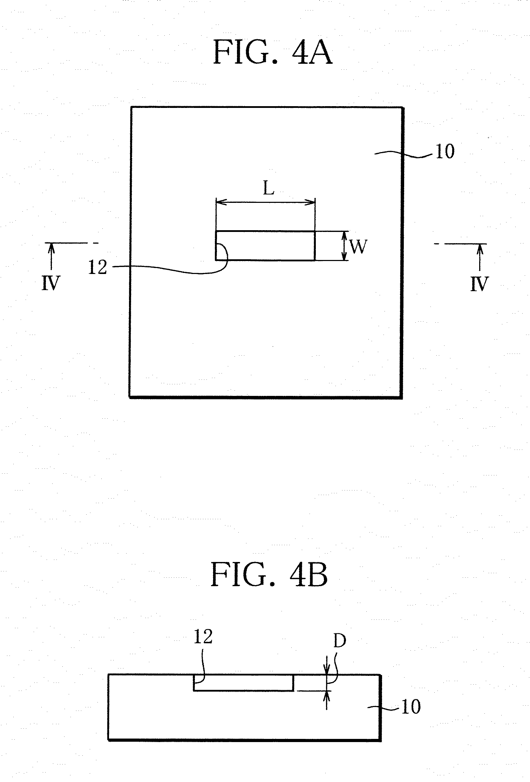

FIG. 4A is a top view of the test object 10 used in each example described below, whereas FIG. 4B is a cross-sectional view taken along the IV-IV line of FIG. 4A. An artificial flaw 12 is formed in the titanium material used in the present examples. As illustrated in FIGS. 4A and 4B, the artificial flaw 12 is formed so as to be L in flaw length, W in flaw width, and D in flaw depth. These flaw length L, flaw width W and flaw depth D were varied respectively, and eddy-current flaw detection was performed using the above-described eddy-current flaw detection method, while moving the probe 8 in the direction of an arrow shown in FIG. 4A. Note that in the present examples, an amorphous magnetic wire 2 mm in length and 20 µm in diameter was used. In each example discussed hereinafter, a case will also be shown, as a comparative example, in which eddy-current flaw detection was performed without synchronizing the phase of a signal frequency applied to the exciting coil 2 and the phase of a signal frequency applied to the amorphous magnetic wire 3, as has been practiced conventionally.

### <Example 1>

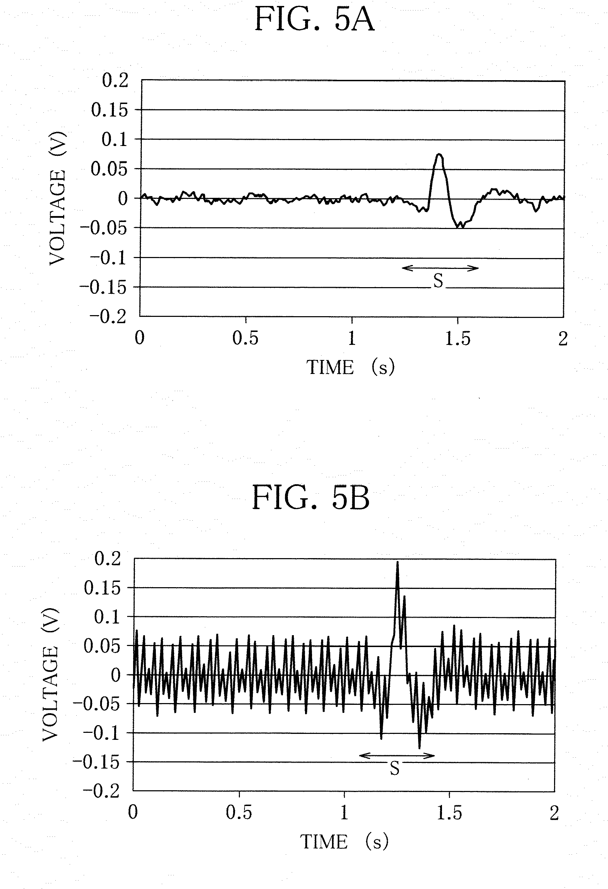

For a titanium material in which an artificial flaw 12, 0.6 mm in flaw length L, 0.08 mm in flaw width W and 0.3 mm in flaw depth D, was formed, an impedance change was measured by setting the frequency of an exciting coil driving voltage to 1 MHz and the frequency of a wire driving voltage to 15 MHz and applying signal frequencies to the exciting coil 2 and the amorphous magnetic wire 3, respectively. Each of FIGS. 5A and 5B shows the result of the measurement.

FIG. 5A shows the measurement results when eddy-current flaw detection was performed using the eddy-current flaw detection method according to the present invention, whereas FIG. 5B shows the measurement results when eddy-current flaw detection was performed, as a comparative example, without synchronizing the phase of the frequency of a voltage applied to the exciting coil 2 and the phase of the frequency of a voltage applied to the amorphous magnetic wire 3. A range S shown in each of FIGS. 5A and 5B denotes a range of voltage change when the probe 8 passed through the artificial flaw 12 formed in the titanium material.

From the results shown in FIG. 5A obtained by the eddy-current flaw detection method according to the present invention, it is understood that noise has been reduced significantly, compared with the results based on a conventional eddy-current flaw detection method represented in FIG. 5B. An S/N ratio was 6.8 when eddy-current flaw detection was performed using the eddy-current flaw detection method according to the present invention represented in FIG. 5A. On the other hand, an S/N ratio was 2.6 when eddy-current flaw detection was performed using the conventional flaw detection method represented in FIG. 5B. As described above, if eddy-current flaw detection is performed using the eddy-current flaw detection method according to the present invention represented in FIG. 5A, noise can be reduced as a whole, compared with the conventional flaw detection method. It is thus understood that even minor flaws can be detected with a high degree of accuracy.

### <Example 2>

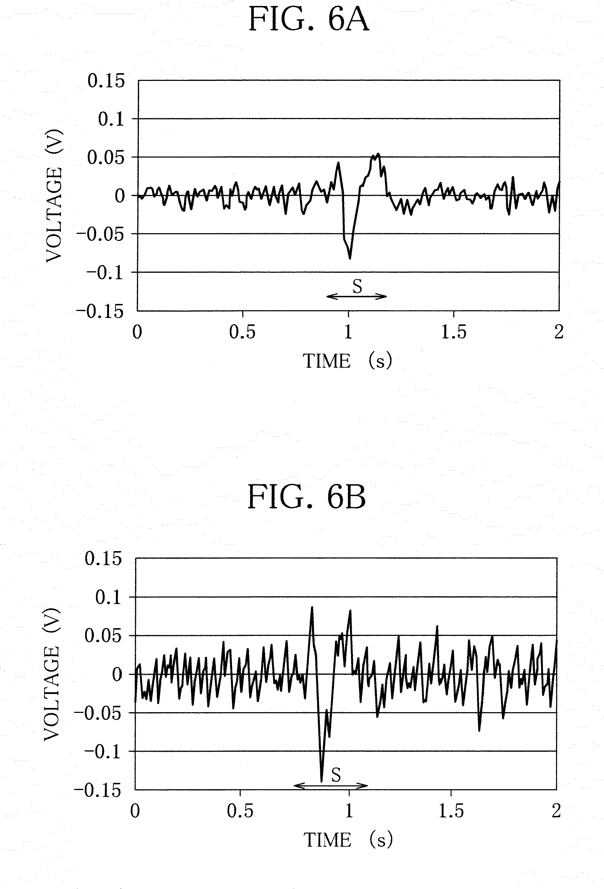

For a titanium material in which an artificial flaw 12, 0.6 mm in flaw length L, 0.08 mm in flaw width W and 0.3 mm in flaw depth D, was formed, an impedance change was measured by setting the frequency of an exciting coil driving voltage to 2 MHz and the frequency of a wire driving voltage to 25 MHz and applying voltages to the exciting coil 2 and the amorphous magnetic wire 3, respectively. Each of FIGS. 6A and 6B shows the result of the measurement.

FIG. 6A shows the measurement results when eddy-current flaw detection was performed using the eddy-current flaw detection method according to the present invention, whereas FIG. 6B shows the measurement results when eddy-current flaw detection was performed, as a comparative example, without synchronizing the phase of the frequency of a voltage applied to the exciting coil 2 and the phase of the frequency of a voltage applied to the amorphous magnetic wire 3. A range S shown in each of FIGS. 6A and 6B is the same as those discussed in Example 1 described above.

As illustrated in FIG. 6A, an S/N ratio when eddy-current flaw detection was performed using the eddy-current flaw detection method according to the present invention was 3.4. On the other hand, an S/N ratio when eddy-current flaw detection was performed using the conventional flaw detection method represented in FIG. 6B was 1.9. In this way, it has been confirmed that the same advantageous effect as in Example 1 described above can be obtained.

### <Example 3>

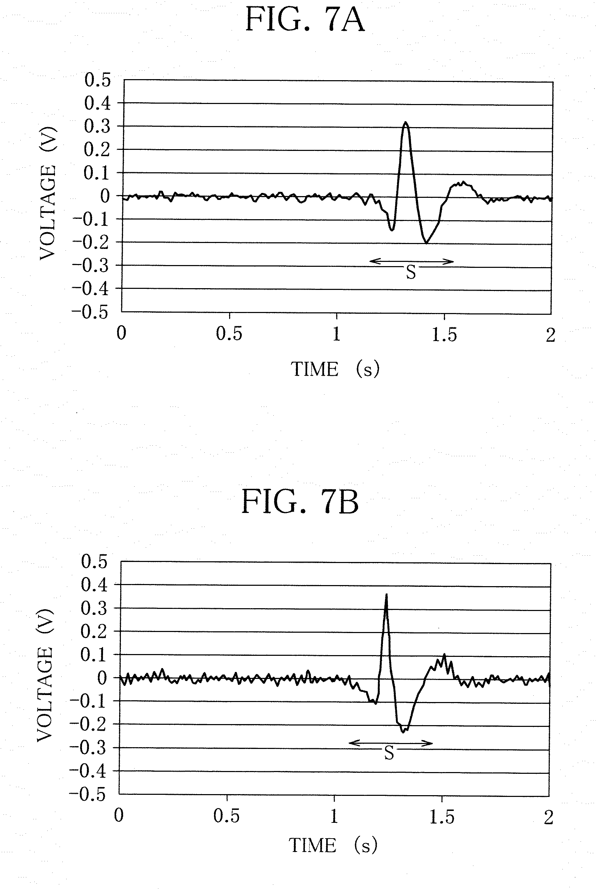

For a titanium material in which an artificial flaw 12, 3.0 mm in flaw length L, 0.3 mm in flaw width W and 0.8 mm in flaw depth D, was formed, an impedance change was measured by setting the frequency of an exciting coil driving voltage to 100 kHz and the frequency of a wire driving voltage to 25 MHz and applying voltages to the exciting coil 2 and the amorphous magnetic wire 3, respectively. Each of FIGS. 7A and 7B shows the result of the measurement.

FIG. 7A shows the measurement results when eddy-current flaw detection was performed using the eddy-current flaw detection method according to the present invention, whereas FIG. 7B shows the measurement results when eddy-current flaw detection was performed, as a comparative example, without synchronizing the phase of the frequency of a voltage applied to the exciting coil 2 and the phase of the frequency of a voltage applied to the amorphous magnetic wire 3. A range S shown in each of FIGS. 7A and 7B is the same as those discussed in Example 1 described above.

As illustrated in FIG. 7A, an S/N ratio when eddy-current flaw detection was performed using the eddy-current flaw detection method according to the present invention was 13.4. On the other hand, an S/N ratio when eddy-current flaw detection was performed using the conventional flaw detection method represented in FIG. 7B was 9.8. It has therefore been confirmed that the same advantageous effect as in Example 1 described above can be obtained even if the frequency of a voltage applied to the exciting coil 2 is low as in the present example.

From the foregoing, there has been drawn the conclusion that it is possible to precisely detect flaws present on the inspection surface 11 of the test object 10 by setting the frequency of a voltage to be applied to the exciting coil 2 to 100 kHz to 2 MHz and the frequency of a voltage to be applied to the amorphous magnetic wire 3 to 10 MHz or higher, as frequencies used in the eddy-current flaw detection apparatus 1 and the eddy-current flaw detection method of the present embodiment.

Given the above, since favorable results have been proven to be available by selecting the frequency of a voltage from the range of 100 kHz to 2 MHz for the exciting coil 2, the same advantageous effect can be obtained by selecting the frequency of the voltage of the exciting coil 2 from the range of 100 kHz to 10 MHz.

### Explanation of Reference Signs

1 Eddy-current flaw detection apparatus
2 Exciting coil
3 Amorphous magnetic wire (magnetoimpedance effect device)
4 Exciting coil driving signal generator (coil driving means)
5 Sensor circuit
6 Detector circuit
10 Test object
51 Wire driving signal generator (device driving means)
52 Response signal extraction circuit

## Claims

1. An eddy-current flaw detection method comprising:
a synchronization step of synchronizing the phase of an exciting voltage applied by coil driving means (4) to an exciting coil (2) for generating an eddy current in a test object (10) with the phase of a driving voltage, higher in frequency than the exciting voltage, applied by device driving means (51) to a magnetoimpedance effect device (3) for detecting variation of a magnetic field arising in the exciting coil (2); and
a magnetic field detection step of detecting the variation of the magnetic field arising in the exciting coil (2) due to the eddy current generated in the test object (10) using the magnetoimpedance effect device (3).

2. The eddy-current flaw detection method according to claim 1, wherein the synchronization step is carried out as the result of a trigger signal being input from the coil driving means (4) to the device driving means (51) and, upon input of the trigger signal, the driving voltage is output from the device driving means (51) in the form of a burst wave.

3. The eddy-current flaw detection method according to claim 1 or 2, wherein the exciting coil (2) is a whorl-like coil, and the magnetoimpedance effect device (3) is disposed so as to extend from a center side of the exciting coil (2) toward an outer edge of the exciting coil (2) in a radial direction thereof.

4. An eddy-current flaw detection apparatus (1) comprising:
an exciting coil (2) for generating an eddy current in a test object (10); a magnetoimpedance effect device (3) for detecting a variation in the magnetic field of the exciting coil (2); coil driving means (4) for exciting the exciting coil (2) by applying an exciting voltage having a predetermined frequency to the exciting coil (2); device driving means (51) for applying a driving voltage, higher in frequency than the voltage of the exciting coil (2), to the magnetoimpedance effect device (3); the eddy-current flaw detection apparatus (1) being **characterized in that** it further comprises synchronization means for synchronizing the phase of the exciting voltage applied by the coil driving means (4) with the phase of the driving voltage applied by the device driving means (51).

5. The eddy-current flaw detection apparatus (1) according to claim 4, wherein the synchronization means outputs a driving voltage from the device driving means (51) in the form of a burst wave when a trigger signal is input from the coil driving means (4) to the device driving means (51).

6. The eddy-current flaw detection apparatus (1) according to claim 4 or 5, wherein the exciting coil (2) is a whorl-like coil, and the magnetoimpedance effect device (3) is disposed so as to extend from a center side of the exciting coil (2) toward an outer edge of the exciting coil (2) in a radial direction thereof.

## Patentansprüche

1. Wirbelstromfehlererfassungsverfahren, folgendes umfassend:
einen Synchronisatonssschritt zum Synchronisieren der Phase einer Erregerspannung, die durch eine Spulenantriebseinrichtung (4) an eine Erregerspule (2) angelegt wird, um einen Wirbelstrom in einem Prüfobjekt (10) mit der Phase einer Antriebsspannung zu erzeugen, die von einer höheren Frequenz ist als die Erregerspannung, die durch eine Vorrichtungsantriebseinrichtung (51) an eine Magnetoimpedanzeffektvorrichtung (3) angelegt wird, um eine Veränderung eines Magnetfelds zu erfassen, das in der Erregerspule (2) auftritt; und
einen Magnetfelderfassungsschritt zum Erfassen der Veränderung des Magnetfelds, das in der Erregerspule (2) aufgrund des im Prüfobjekt (10) erzeugten Wirbelstroms auftritt, unter Verwendung der Magnetoimpedanzeffektvorrichtung (3).

2. Wirbelstromfehlererfassungsverfahren nach Anspruch 1, wobei der Synchronisationsschritt als Ergebnis dessen ausgeführt wird, dass ein Auslösesignal ausgehend von der Spulenantriebseinrichtung (4) in die Vorrichtungsantriebseinrichtung (51) eingegeben wird, und auf die Eingabe des Auslösesignals hin die Antriebsspannung aus der Vorrichtungsantriebseinrichtung (51) in Form einer Burst-Welle ausgegeben wird.

3. Wirbelstromfehlererfassungsverfahren nach Anspruch 1 oder 2, wobei es sich bei der Erregerspule (2) um eine quirlartige Spule handelt und die Magnetoimpedanzeffektvorrichtung (3) sich von einer Mittenseite der Erregerspule (2) zu einem Außenrand der Erregerspule (2) in einer radialen Richtung von dieser erstreckend angeordnet ist.

4. Wirbelstromfehlererfassungsvorrichtung (1), folgendes umfassend:
eine Erregerspule (2), um einen Wirbelstrom in einem Prüfobjekt zu erzeugen;
eine Magnetoimpedanzeffektvorrichtung (3), um eine Veränderung im Magnetfeld der Erregerspule (2) zu erfassen;
eine Spulenantriebseinrichtung (4), um die Erregerspule (2) zu erregen, indem eine Erregerspannung mit einer vorbestimmten Frequenz an die Erregerspule (2) angelegt wird;
eine Vorrichtungsantriebseinrichtung (51), um eine Antriebsspannung, die von einer höheren Frequenz ist als die Spannng der Erregerspule, an die Magnetoimpedanzeffektvorrichtung (3) anzulegen;
wobei die Wirbelstromfehlererfassungsvorrichtung (1) **dadurch gekennzeichnet ist, dass** sie darüber hinaus eine Synchronisationseinrichtung umfasst, um die Phase der an die Spulenantriebseinrichtung (4) angelegten Erregerspannung mit der Phase der durch die Vorrichtungsantriebseinrichtung (51) angelegten Antriebsspannung zu synchronisieren.

5. Wirbelstromfehlererfassungsvorichtung (1) nach Anspruch 4, wobei die Synchronisationseinrichtung eine Antriebsspannung aus der Vorrichtungsantriebseinrichtung (51) in Form einer Burst-Welle ausgibt, wenn ein Auslösesignal ausgehend von der Spulenantriebseinrichtung (4) in die Vorrichtungsantriebseinrichtung (51) eingegeben wird.

6. Wirbelstromfehlererfassungsvorichtung (1) nach Anspruch 4 oder 5, wobei es sich bei der Erregerspule (2) um eine quirlartige Spule handelt und die Magnetoimpedanzeffektvorrichtung (3) sich von einer Mittenseite der Erregerspule (2) zu einem Außenrand der Erregerspule (2) in einer radialen Richtung von dieser erstreckend angeordnet ist.

## Revendications

1. Procédé de détection de défaut par courant de Foucault comprenant :
une étape de synchronisation consistant à synchroniser la phase d'une tension d'excitation appliquée par des moyens d'entraînement de bobine (4) à une bobine d'excitation (2) destinée à générer un courant de Foucault dans un objet de test (10) avec la phase d'une tension d'entraînement, supérieure en fréquence à la tension d'excitation, appliquée par des moyens d'entraînement de dispositif (51) à un dispositif à effet de magnéto-impédance (3) destiné à détecter une variation d'un champ magnétique survenant dans la bobine d'excitation (2) ; et
une étape de détection de champ magnétique consistant à détecter la variation du champ magnétique survenant dans la bobine d'excitation (2) en raison du courant de Foucault généré dans l'objet de test (10) moyennant le dispositif à effet de magnéto-impédance (3).

2. Le procédé de détection de défaut par courant de Foucault selon la revendication 1, sachant que l'étape de synchronisation est effectuée en tant que le résultat d'un signal de déclenchement qui est entré depuis les moyens d'entraînement de bobine (4) vers les moyens d'entraînement de dispositif (51) et, lors de l'entrée du signal de déclenchement, la tension d'entraînement est sortie depuis les moyens d'entraînement de dispositif (51) sous la forme d'une onde en rafale.

3. Le procédé de détection de défaut par courant de Foucault selon la revendication 1 ou 2, sachant que la bobine d'excitation (2) est une bobine de type verticille, et le dispositif à effet de magnéto-impédance (3) est disposé de façon à s'étendre depuis un côté central de la bobine d'excitation (2) vers un bord extérieur de la bobine d'excitation (2) dans une direction radiale de celle-ci.

4. Appareil de détection de défaut par courant de Foucault (1) comprenant :
une bobine d'excitation (2) destinée à générer un courant de Foucault dans un objet de test (10) ;
un dispositif à effet de magnéto-impédance (3) destiné à détecter une variation dans le champ magnétique de la bobine d'excitation (2) ;
des moyens d'entraînement de bobine (4) destinés à exciter la bobine d'excitation (2) en appliquant une tension d'excitation ayant une fréquence prédéterminée à la bobine d'excitation (2) ;
des moyens d'entraînement de dispositif (51) destinés à appliquer une tension d'entraînement, supérieure en fréquence à la tension de la bobine d'excitation (2), au dispositif à effet de magnéto-impédance (3) ;
l'appareil de détection de défaut par courant de Foucault (1) étant **caractérisé en ce qu'**il comprend en outre
des moyens de synchronisation destinés à synchroniser la phase de la tension d'excitation appliquée par les moyens d'entraînement de bobine (4) avec la phase de la tension d'entraînement appliquée par les moyens d'entraînement de dispositif (51).

5. L'appareil de détection de défaut par courant de Foucault (1) selon la revendication 4, sachant que les moyens de synchronisation sortent une tension d'entraînement depuis les moyens d'entraînement de dispositif (51) sous la forme d'une onde en rafale lorsqu'un signal de déclenchement est entré depuis les moyens d'entraînement de bobine (4) vers les moyens d'entraînement de dispositif (51).

6. L'appareil de détection de défaut par courant de Foucault (1) selon la revendication 4 ou 5, sachant que la bobine d'excitation (2) est une bobine de type verticille, et le dispositif à effet de magnéto-impédance (3) est disposé de façon à s'étendre depuis un côté central de la bobine d'excitation (2) vers un bord extérieur de la bobine d'excitation (2) dans une direction radiale de celle-ci.
